Europäisches Patentamt

European Patent Office

Office européen des brevets

(19)

(11) Publication number: **0 102 218**
**B1**

# (12) EUROPEAN PATENT SPECIFICATION

(45) Date of publication of patent specification: **25.07.90**

(51) Int. Cl.⁵: **G 11 C 7/00**

(21) Application number: **83304743.4**

(22) Date of filing: **16.08.83**

(54) **Sense amplifier circuit for semiconductor memory.**

(30) Priority: **20.08.82 JP 144235/82**

(43) Date of publication of application:
**07.03.84 Bulletin 84/10**

(45) Publication of the grant of the patent:
**25.07.90 Bulletin 90/30**

(84) Designated Contracting States:
**DE FR GB**

(56) References cited:
**EP-A-0 047 001**
**EP-A-0 050 484**
**GB-A-1 174 720**

**RADIO FERNSEHEN ELEKTRONIK, vol. 26, no. 9,
May 1977, pages 307-310, Berlin, DE; K.KUPFER:
"Die Differenzkaskodestufe"**

(73) Proprietor: **KABUSHIKI KAISHA TOSHIBA
72, Horikawa-cho Saiwai-ku
Kawasaki-shi Kanagawa-ken 210 (JP)**

(72) Inventor: **Miyamoto, Junichi Patent Div. Tokyo
Shibaura
Denki K.K. 72, Horikawa-cho Saiwai-ku
Kawasaki-shi Kanagawa-ken Tokyo (JP)**

(74) Representative: **Shindler, Nigel et al
BATCHELLOR, KIRK & CO. 2 Pear Tree Court
Farringdon Road
London EC1R 0DS (GB)**

Courier Press, Leamington Spa, England.

## Description

This invention relates to a semiconductor circuit and especially to a sense amplifier circuit for a semiconductor memory device having MOS (Metal Oxide Semiconductor) type transistor memory cells.

Various types of sense amplifier circuits are employed in conventional semiconductor memory devices. To obtain high speed and low power characteristics, CMOS (Complementary Metal Oxide Semiconductor) circuits are often used for the sense amplifier. A typical one is disclosed in "1982 IEE International Solid State Circuits Conferences Digest of Technical Papers, pages 256—257". This circuit consists of two single-ended active load differential amplifiers. Each amplifier comprises two P-channel load transistors connected to a constant voltage supply and two N-channel sensing transistors connected between the load transistors and the earth voltage respectively. The gate electrodes of the sensing transistors are connected to two bit lines respectively. The bit lines are connected to the memory cell array. According to the information stored in the memory cells, the voltage balance of two bit lines are changed. The sense amplifier detects and amplifies the change of the voltage balance.

In order to achieve a high speed characteristic, consideration must be given to the layout of the transistors. Generally the time t in which the change of the voltage balance of the two bit lines V appears after the memory is accessed, has the following relationship.

$$t \cong C_{BL} \cdot V/I$$

Here, $C_{BL}$ is the capacitance attached to the bit line and I is the current flowing through the bit line. Accordingly, the following conditions may be required to achieve the high speed response.

(1) Reducing the bit line capacitance $C_{BL}$
(2) Reducing the voltage channel $\Delta V$
(3) Making the bit line current I larger.

It is, however, difficult to realise the first and third conditions. Namely, first of all, in order to achieve a higher cell packing density, which is another important requirement for the memory device, the channel width of transistors constructing the memory cells must be smaller. Therefore the bit line current may also be smaller. Next, as the number of cells connected to a bit line increases, the number of transfer gate transistors connected between the bit line and the memory cells, also increases. This results in an increase in the capacitance of the bit line.

Accordingly it is necessary to realise the second condition to achieve a high speed response. However, it is also difficult to set up the $\Delta V$ at a smaller level. If the $\Delta V$ becomes smaller, the conductance of the sensing transistors must be larger and the channel width of the transistor must be larger. This reduces the possible packing density. Further, when $\Delta V$ is low, the distribution of Vth generated on manufacturing process affects the characteristic of the device seriously.

There is another problem with the conventional device. Namely, the change of bit line voltage $\Delta V$ occurs close to the supply voltage $V_{DD}$, but the most sensitive voltage range of the sense amplifier is near the threshold voltage $V_{th}$ of MOS sensing transistor. Generally $V_{th}$ is so far from $V_{DD}$ that the sensing ability is not effectively used.

It is accordingly an object of this invention to provide a sense amplifier circuit for a semiconductor memory device with high speed and high packing density.

It is another object of this invention to provide a sense amplifier circuit for semiconductor memory device with high sensitivity and high input impedance characteristic.

In order to achieve the above mentioned object, this invention provides a sense amplifier circuit comprising a first and second bipolar sensing transistors, and second load MOS transistor connected to said first and second sensing transistors respectively, a constant voltage supply ($V_{DD}$) connected to said first and second load MOS transistor, first and second input terminals coupled to control electrodes of said first and second sensing transistors respectively, first and second output terminals ($V_o$) coupled to connecting points of said first and second sensing transistors and load MOS transistor respectively, and a constant current supply connected to said first and second sensing transistors, characterised in that said constant current supply comprises an MOS transistor having a conductance value sufficient to prevent the collector voltages of the bipolar transistors from falling to a low level and in that the conductance value of each said load MOS transistor is larger than that of said constant current supply.

The invention will be described more in detail, with reference to the accompanying drawings in which:

Figure 1 shows a conventional sense amplifier circuit;
Figure 2 shows a first embodiment of this invention;
Figure 3 shows input and output characteristics of this invention;
Figure 4 shows a second embodiment of this invention,
Figure 5 shows a circuit configuration of a semiconductor memory device to which this invention is applied; and
Figure 6 shows the cross sectional view of a device according to this invention.

As mentioned above, it is very difficult to achieve a higher speed characteristic and a higher packing density at the same time by using a sense amplifier comprising MOS transistors. In order to overcome this problem, especially to achieve the higher speed characteristic, bipolar transistors may be used in the sense amplifier.

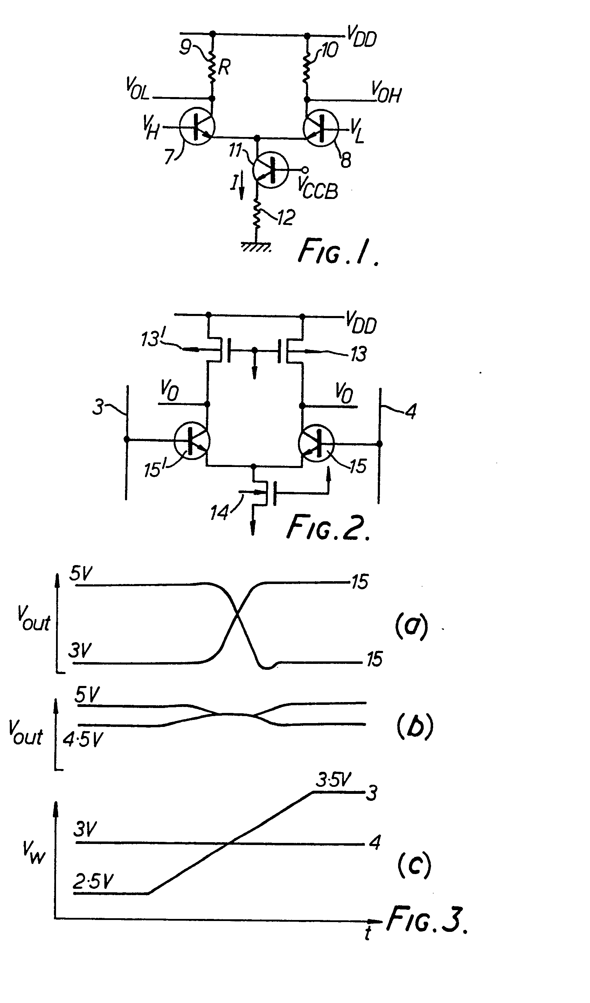

Referring to Figure 1, we will explain a sense amplifier circuit comprising emitter-coupled bipolar transistors used for conventional ECL circuits. In this circuit, input signals $V_H$, $V_L$ are applied to the base electrodes of bipolar transistors 7, 8. The collector electrodes of the transistors 7, 8 are connected to a constant voltage supply $V_{DD}$ through resistors 9, 10 respectively and also connected to the output terminal of this circuit. The emitter electrodes of transistors 7, 8 are connected to a constant current source comprising a bipolar transistor 11, resistor 12 and a control voltage supply $V_{CCB}$. In this circuit, the ratio $I_H$ to $I_L$ is as follows, designating that $I_H$ is the current in the higher bit line and $I_L$ in the lower one.

$$I_H/I_L \cong \exp(q/KT . \Delta V).$$

Here, q is the elementary electric charge, K is Boltzman's constant and T is temperature. In the case that $KT/q = 25$ mV, $\Delta V = 0.4V$, $I_H/I_L$ becomes $10^7$. Further, the difference of the lower output voltage $V_{OL}$ from the higher output voltage $V_{OH}$ is as follows,

$$V_{OH} - V_{OL} = R(I_H - I_L) \cong RI_H \cong RI$$

The bipolar transistor has very high sensitivity because the collector current is very sensitive to changes in the bit line voltage. Further, the bipolar transistor also has the advantage of small distribution generated on manufacturing process.

However the bipolar transistor also causes the following problem in this circuit. That is, it needs more elements than an MOS circuit, especially it needs an extra constant voltage source $V_{CCB}$ controlling the constant current source. Further, the resistors 9, 10 occupy a very large area on the chip because the resistance must be large in order to obtain a suitable output voltage.

According to our invention, these problems which are particular to bipolar transistor circuits may also be overcome.

Referring to Figure 2, we will explain a first embodiment of this invention. This sense amplifier comprises a pair of NPN bipolar transistors 15, 15' whose base electrodes are connected to bit lines 3, 4 respectively, a pair of load P-channel MOS transistors 13, 13' connected between the constant voltage source $V_{DD}$ and collector electrodes of the bipolar transistors 15, 15', and on N-channel MOS TRANSISTOR 14 which is used as a constant current source and connected between the emitter electrodes of the bipolar transistors 15, 15' and the earth voltage. A similar circuit, but with a constant current source implemented by a resistor, is described in GB—A—1 174 720.

One of the particular features of the embodiment in Figure 2 is that MOS transistors are used for load resistors and a constant current source. That is, this embodiment utilsies the characteristic that the MOS transistor has a high impedance but occupies a small area on the chip.

In this embodiment, P-channel type MOS transistors are used as load transistors and N-channel type MOS transistors are used to form a constant current source. However, when a PNP type bipolar transistor is used for sensing, the conductivity type of those MOS transistors may of course be opposite to those of this embodiment. Further, $V_{DD}$ and the earth terminal may be exchanged.

In this circuit operation, it is necessary to use the sensing bipolar transistors, 15, 15' in the unsaturated region because the speed of operation drops considerably in the saturated region. For this reason, the collector voltage must be set up so as not to be too much lower than the base voltage. This relation is achieved by setting the Imax of the load MOS 13, 13' to be lower than that of the constant current source 14. This condition is formulated as follows,

$$\beta L(V_{GS,L} - V_{th,L})^2 \gg \beta c(V_{GS.c} - V_{th,c})^2.$$

Here, $\beta$ is a constant value depending on the structure of the transistor. $V_{GS}$ is gate-source voltage and $V_{th}$ is a threshold voltage. The suffix L and C designates load transistor and constant current source respectively. In case $V_{GS,L} = V_{GS,c} = V_{DD}$ and $V_{th,L} = V_{th,c}$, the condition becomes as follows,

$$\beta L \gg \beta C.$$

This equation means that the conductance of the load transistor 13, 13' must be much larger than that of the current source 14. However, it is necessary to take care of the fact that the output voltages from the collector of the bipolar transistoirs 15, 15' fall to a lower level if the conductance of the current source 14 is set up at an excessively low level.

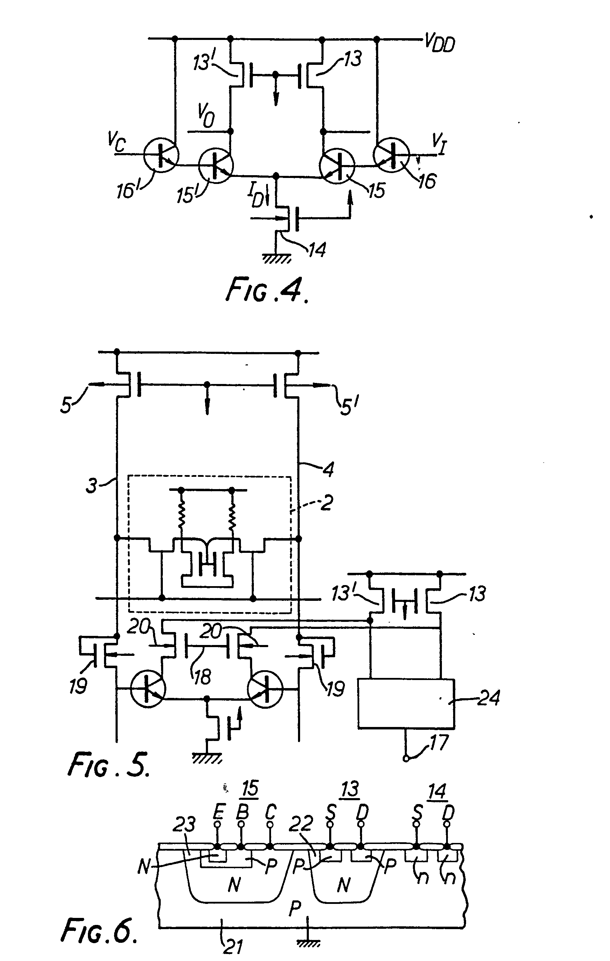

Figure 3a—3c shows the input-output characteristic of this embodiment. Figure 3a shows the output signals of this invention. Figure 3b shows the output signals of a conventional circuit, and Figure 3c shows the input signals or bit line voltages. The operation of this embodiment will be explained with reference to Figures 2 and 3a to 3c. At first, the bit line 3 is set up at a lower level and the bit line 4 at a higher level. In this situation there is no collector current flowing in the transistor 15', on the other hand a certain collector current does flow in the transistor 15. Therefore the former output voltage is at a high level and the latter is low. After the memory cell connected to the bit line 3 is accessed and the charge stored in the cell is read out, the voltage of the bit line 3 rises to a higher level. Then a collector current begins to flow in the transistor 15' whilst that of the transistor 15 decreases. Finally the transistor 15' turns on and the transistor 15 turns off and the output voltages exchange their position. Comparing Figure 3a with Figure 3b, it is clear that this embodiment achieves higher speed and amplification characteristics.

Figure 4 shows a second embodiment of this invention. In this embodiment, a Darlington coupled circuit is provided in order to sense the bit line voltage balance. This is achieved by adding another pair of NPN bipolar transistors 16, 16' to the circuit of Figure 2. The input signals from the bit lines are applied to the base electrodes of the transistors 16, 16', whose emitter electrodes are connected to the base electrodes of the transistors 15, 15' respectively and collector electrodes to the constant voltage supply $V_{DD}$. This embodiment has the following advantages. It does not need such a large base current and the input impedance is still large. Further, the output voltage can be set up at a higher level because the unsaturated region of the sensing transistor is wide.

Figure 5 shows an SRAM circuit in accordance with the first embodiment of this invention. In this circuit, P-channel MOS transistors 5, 5', are coupled to the bit lines 3, 4 respectively. These transistors 5, 5' are used to precharge the bit lines 3, 4. The load MOS transistors 13, 13' are coupled to the collector electrodes of NPN transistors via transfer gate MOS transistor 20, which is controlled by column decoding signal applied to the gate electrode 18. The memory cell 2 is connected to the bit lines 3, 4. The bit line has N-channel MOS transistor 19 in order to shift the voltage level of the bit line. By means of this transistor 19, the voltage level of the bit line is held at a relatively lower level than $V_{DD}$ so that the difference between the output voltages of the sense amplifier can be made large.

As a result, the size of the main amplifier and output driver 24 which amplifies and drives the output signal to the terminal 17, can be reduced and the operation becomes faster.

Figure 6 shows a cross sectional view of a device including the main portion of the circuit in Figure 2. This device comprises a P type silicon substrate 21 in which a load transistor 13, a constant current source 14 and sensing transistor 15 are formed. The load transistor 13 comprises an N-type well 22 and P type source of drain regions formed therein. The constant current source 14 comprises a N-type source of drain regions formed in the substrate. The sensing transistor 15 comprises an N-type well collector region, P-type base region and N-type emitter region. This structure can be formed by the use of a conventional C MOS process without any additional steps.

## Claims

1. A sense amplifier circuit comprising a first and second bipolar sensing transistors (15, 15'), first and second load MOS transistor (13, 13') connected to said first and second sensing transistors respectively, a constant voltage supply ($V_{DD}$) connected to said first and second load MOS transistor, first and second input terminals (3, 4) coupled to control electrodes of said first and second sensing transistors respectively, first and second output terminals ($V_o$) coupled to connecting points of said first and second sensing transistors and load MOS transistor respectively, and a constant current supply (14) connected to said first and second sensing transistors, characterised in that said constant current supply comprises an MOS transistor having a conductance value sufficient to prevent the collector voltages of the bipolar transistors (15, 15') from falling to a low level, and in that the conductance value of each said load MOS transistor is larger than that of said constant current supply.

2. A sense amplifier circuit according to claim 1 further characterised in that, each said load MOS transistor (13, 13') is a P channel MOS transistor and said constant current supply (14) comprises an N channel MOS transistor and each said sensing transistor (15, 15') is an NPN type bipolar transistor, the base electrode of each said sensing transistor being connected to said input terminal (3 or 4), the emitter electrode to said constant current supply (14) and the collector electrode to said output terminal.

3. A sense amplifier circuit according to claims 1 or 2 further characterised in that; said first and second bipolar sensing transistors are connected to third and fourth bipolar transistors (16, 16') respectively so as to form Darlington pairs, said third and fourth bipolar transistors being connected to said first and second input terminals respectively.

4. A sense amplifier circuit according to claim 1 or claim 2 further characterised in that each of said first and second input terminals (3, 4) is a bit line constituting an SRAM circuit.

5. A sense amplifier circuit according to claim 1 or claim 2 further characterised in that said MOS load transistors (13, 13'), said first and second sensing bipolar transistors (15, 15') and said MOS transistor of constant current supply (14) are formed on a common substrate.

6. A sense amplifier circuit according to claim 5 further characterised in that said MOS load transistors (13, 13') are P-channel types and in that said MOS transistor of constant current supply (14) is an N-channel type to facilitate formation as a CMOS integrated circuit together with the MOS load transistors (13, 13').

## Patentansprüche

1. Leseverstärkerschaltung mit ersten und zweiten bipolaren Lesetransistoren (15, 15'), ersten und zweiten Last-MOS-Transistoren (13, 13'), die jeweils an die ersten und zweiten Lesetransistoren angeschlossen sind, mit einer Konstantspannungsversorgung ($V_{DD}$), die an den ersten und zweiten Last-MOS-Transistor angeschlossen ist, mit ersten und zweiten Eingabeklemmen (3, 4), die an die Steuerelektroden jeweils des ersten und zweiten Lesetransistors angeschlossen sind, mit ersten und zweiten Ausgabeklemmen ($V_o$), die an Anschlußpunkte des ersten und zweiten Lesetransistors bzw. des Last-MOS-Transistors angeschlossen sind, und mit einer Konstantstromversorgung (14), die an den ersten und zweiten Lesetransistor angeschlossen ist, dadurch gekennzeichnet, daß die Konstantstromversorgung einen MOS-Transistor aufweist, dessen Leitfähigkeitswert groß genug ist, um zu verhindern, daß die Kollektorspannungen der bipolaren Transistoren (15, 15') auf einen niederen Wert abfallen, und daß der Leitfähigkeitswert jedes Last-MOS-Transistors größer als der der Konstantstromversorgung ist.

2. Leseverstärkerschaltung nach Anspruch 1, ferner dadurch gekennzeichnet, daß jeder Last-MOS-Transistor (13, 13') ein p-Kanal MOS-Transistor ist und die Konstantstromversorgung (14) einen n-Kanal MOS-Transistor aufweist, und daß jeder Lesetransistor (15, 15') ein npn-Bipolartransistor ist, wobei die Basiselektrode jedes Lesetransistors an die Eingabeklemme (3 oder 4), die Emitterelektrode der Konstantstromversorgung (14) und die Kollektorelektrode an die Ausgabeklemme angeschlossen ist.

3. Leseverstärkerschaltung nach Anspruch 1 oder 2, ferner dadurch gekennzeichnet, daß der erste und zweite bipolare Lesetransistor an einen dritten bzw. vierten bipolaren Transistor (16, 16') angeschlossen ist, um eine Darlington-Schaltung zu bilden, wobei der dritte und vierte bipolare Transistor jeweils an eine zweite Eingabeklemme angeschlossen ist.

4. Leseverstärkerschaltung nach Anspruch 1 oder 2, dadurch gekennzeichnet, daß die erste und zweite Eingabeklemme (3, 4) eine Bit-Leitung ist, die eine SRAM-Schaltung bilden.

5. Leseverstärkerschaltung nach Anspruch 1 oder 2, ferner dadurch gekennzeichnet, daß die MOS-Lasttransistoren (13, 13'), die ersten und zweiten bipolaren Lesetransistoren (15, 15') und der MOS-Transistor der Konstantstromversorgung (14) auf ein und demselben Substrat gebildet sind.

6. Leseverstärkerschaltung nach Anspruch 5, ferner dadurch gekennzeichnet, daß die MOS-Lasttransistoren (13, 13') p-Kanal Typen sind und der MOS-Transistor der Konstantstromversorgung (14) ein n-Kanal Typ ist, um die Bildung einer CMOS-IS zusammen mit den MOS-Lasttransistoren (13, 13') zu ermöglichen.

**Revendications**

1. Circuit d'amplification qui comprend un premier et un second transistors-senseurs bipolaires (15, 15'), un premier et un second transistors de charge MOS (13, 14') connectés respectivement auxdits premier et second transistors, une source de tension constante ($V_{DD}$) connectée auxdits premier et second transistors de charge MOS, une première et une seconde bornes d'entrée (3, 4) couplées aux électrodes de commande desdites premier et second transistors-senseurs, respectivement, une première et une seconde bornes de sortie ($V_o$) couplées aux points de connexion desdits premier et second transistors-senseurs et au transistor de charge MOS respectivement, et une source de courant constante (14) connectée auxdits premier et second transistors-senseurs, caractérisé en ce que ladite source de courant constant comprend un transistor MOS dont l'indice de conductance a une valeur suffisante pour éviter que les tensions de collecteur des transistors bipolaires (15, 15') tombe à un niveau trop bas, et en ce que l'indice de conductance de chacun des transistors de charge MOS est plus grand que celui de ladite source de courant constante.

2. Circuit d'amplification selon la revendication 1, caractérisé en ce que chacun desdits transistors MOS a un canal P et en ce que ladite source de courant constante (14) comprend un transistor MOS à canal N, tandis que chacun desdits transistors-senseurs (15, 15') est un transistor bipolaire de type NPN, la base de chacun desdits transistors étant connectée à ladite borne d'entrée (3 ou 4), tandis que l'émetteur est connecté à ladite source de courant constante (14) et que le collecteur est relié à ladite borne de sortie.

3. Circuit d'amplification selon la revendication 1 ou 2, caractérisé en ce que le premier et le second transistors-senseurs bipolaires sont connectés respectivement au troisième et au quatrième transistors bipolaires (16, 16') de manière à former une paire de Darlington, le troisième et le quatrième transistors bipolaires étant connectés respectivement auxdites première et seconde bornes d'entrée.

4. Circuit d'amplification selon la revendication 1 ou 2, caractérisé en ce que chacune desdites première et seconde bornes d'entrée (3, 4) est une ligne de circulation de bits constituant un circuit SRAM.

5. Circuit d'amplification selon la revendication 1 ou 2, caractérisé en ce que lesdits transistors de charge MOS (13, 13'), lesdits transistors-senseurs bipolaires (15, 15') et ledit transistor MOS constituant la source de courant constante (14) sont formés sur un substrat commun.

6. Circuit d'amplification selon la revendication 5, caractérisé en ce que lesdits transistors de charge MOS (13, 13') sont du type à canal P et en ce que ledit transistor MOS constituant la source de courant constante (14) est du type à canal afin de faciliter la formation d'un circuit intégré CMOS ensemble avec les transistors de charge MOS (13, 13').

FIG. 1.

FIG. 2.

FIG. 3.

$V_{DD}$

$13^I$

$13$

$V_0$

$V_C$

$16^I$ $15^I$ $15$ $16$ $V_I$

$I_D$

$14$

FIG.4.

$5$ $5^I$

$3$ $4$

$2$

$13^I$ $13$

$20$ $20$

$19$ $18$ $19$

$24$

$17$

FIG.5.

$15$ $13$ $14$

E B C S D S D

$23$ $22$

N P P P N P n n

N N

P

$21$

FIG.6.